# EUROPÄISCHE PATENTSCHRIFT

(11) **EP 1 717 500 B1**
(45) Veröffentlichungstag und Bekanntmachung des Hinweises auf die Patenterteilung: **08.08.2007**
(21) Anmeldenummer: 05400014.6
(22) Anmeldetag: 28.04.2005
(51) Int. Cl.: F16K 31/00, H01L 41/09

(54) **Piezo-Biegewandler**
Piezoelectric bending transducer
Transducteur piezo à flexion

(43) Veröffentlichungstag der Anmeldung: 02.11.2006
(73) Patentinhaber: Festo AG & Co., 73734 Esslingen (DE)
(72) Erfinder: Maichl, Martin, 73084 Salach (DE); Wirtl, Hannes, 86956 Schongau (DE)
(74) Vertreter: Abel, Martin

(56) Entgegenhaltungen:
- EP-A- 0 741 914
- EP-A- 1 453 115
- WO-A-98/25061
- US-A- 5 036 419
- US-A1- 2003 160 544

## Beschreibung

Die Erfindung betrifft einen Piezo-Biegewandler, mit einem streifen- oder plattenförmigen Biegewandlerelement, das einen als piezoelektrisch aktivierbarer Arbeitsabschnitt ausgebildeten Längenabschnitt aufweist und an wenigstens einer seiner beiden großflächigen Seiten mit einer einen folienartigen flexiblen Träger und eine darauf verlaufende elektrische Leiterstruktur aufweisenden Flexschaltung bestückt ist, über die die der piezoelektrischen Aktivierung dienende elektrische Kontaktierung des Arbeitsabschnittes erfolgt.

Ein aus der WO 98/25061 A1 bekannter Piezo-Biegewandler dieser Art kommt beim einem Piezoventil zum Einsatz und dient zur Steuerung einer Fluidströmung. Er enthält ein streifenförmiges Biegewandlerelement, das einenends fest eingespannt ist und über einen piezoelektrisch aktivierbaren Arbeitsabschnitt verfügt, der durch Anlegen einer Aktivierungsspannung dem Steuerungszweck entsprechend auslenkbar ist. Die elektrische Kontaktierung der dem Arbeitsabschnitt zugeordneten Elektroden geschieht über eine auf das Biegewandlerelement auflaminierte Flexschaltung bestehend aus einem dünnen, flexiblen Träger und einer darauf verlaufenden elektrischen Leiterstruktur, auch bezeichenbar als flexible Leiterplatte.

Es wäre wünschenswert, beim Betrieb eines Piezo-Biegewandlers mindestens eine betriebsrelevante Zustandsgröße erfassen zu können. Derartiges wird in der EP 1 453 115 A1 vorgeschlagen, die ein Biegewandlerelement beschreibt, dessen Längsdehnung und folglich auch Auslenkung mittels eines Dehnungsmessstreifens oder einer vergleichbaren Sensoreinrichtung erfasst werden kann, die unmittelbar auf die Oberfläche des Biegewandlerelementes aufgebracht ist. Die für die elektrische Kontaktierung der Sensoreinrichtung und deren exakte Ausrichtung bezüglich dem Biegewandlerelement zu treffenden Maßnahmen sind allerdings relativ aufwändig.

Es ist die Aufgabe der vorliegenden Erfindung, Maßnahmen vorzuschlagen, die in Verbindung mit dem Einsatz eines Piezo-Biegewandlers eine einfache und kostengünstige Zustandsüberwachung ermöglichen.

Zur Lösung dieser Aufgabe ist bei einem Piezo-Biegewandler der eingangs genannten Art vorgesehen, dass ein Teil der Leiterstruktur der Flexschaltung im Bereich des Arbeitsabschnittes des Biegewandlerelementes unmittelbar selbst mindestens einen wenigstens eine Zustandsgröße erfassenden Sensor bildet.

Die auch als "flexible Leiterplatte" bezeichenbare Flexschaltung beinhaltet somit nicht nur die für die Aktivierung des Arbeitsabschnittes benötigten Zuleitungen sondern auch eine Sensorik. Beim Applizieren der Flexschaltung am Biegewandlerelement wird somit automatisch auch die Sensorik installiert, für deren Montage mithin kein gesonderter Arbeitsgang und insbesondere auch keine gesonderten Ausrichtmaßnahmen notwendig sind. Einen ganz wesentlichen Beitrag zur Kostenreduzierung liefert die Realisierung des mindestens einen Sensors durch entsprechende Gestaltung der Leiterstruktur, was die Verwendung eigenständiger Sensoren, beispielsweise spezieller Dehnungsmessstreifen, sowie zugehörige Bestückungsmaßnahmen, erübrigt. Zwar wird in manchen Fällen die mit den erfindungsgemäßen Sensormaßnahmen erzielte Messgenauigkeit geringer sein als diejenige eines gesonderten, speziellen Sensors, aber für viele Anwendungen reicht eine mittelmäßige Genauigkeit oder nur qualitative Messaussage aus, um für den Betrieb des Piezo-Biegewandlers relevante Regelungsaufgaben oder dergleichen ausführen zu können.

Bei einer bevorzugten Ausgestaltung ist die Leiterstruktur so gestaltet, dass sie mindestens einen Auslenkungssensor bildet, der die Auslenkung des Biegewandlerelements erfasst. Hierzu kann die Leiterstruktur zu einer Widerstandsmessbrücke verschaltete Leiterzüge aufweisen. Selbst wenn die Messgenauigkeit hier geringer ist als vergleichbar beim Einsatz konventioneller Dehnungsmessstreifen, kann damit doch beispielsweise ein unerwünschtes Driften des durch Aktivierung ausgelenkten Arbeitsabschnittes erfasst und dementsprechend gegengeregelt werden. Ein solcher Einsatz erlaubt beispielsweise ein zuverlässiges Konstanthalten der Gasströmungsrate bei einem mit Gas beheizten Herd oder Backofen. Somit eröffnen sich auch bei gasbetriebenen Küchengeräten kostengünstige Möglichkeiten für elektronisch gesteuerte Betriebsweisen.

Die Leiterstruktur kann gleichzeitig mehrere gleichartige oder verschiedenartige Sensoren definieren. Die Art des gebildeten Sensors hängt vom Anwendungsfall und vom gewünschten Regelungszweck ab. Beispielsweise können mittels eines Temperatursensors, eines Drucksensors oder eines Feuchtesensors die in der unmittelbaren Nachbarschaft des Biegewandlerelementes herrschenden Zustandsgrößen Temperatur, Druck oder Feuchtigkeit gemessen werden.

Der elektrische Anschluss der gesamten Leiterstruktur geschieht zweckmäßigerweise zentral im Bereich eines einem Endbereich des Biegewandlerelementes zugeordneten Anschlussabschnittes, der in der Regel nicht piezoelektrisch aktivierbar ist. Über diesen Anschlussabschnitt kann sich die Flexschaltung hinweg erstrecken. Sie kann prinzipiell beliebig weit über das Biegewandlerelement hinausragen und dort mit dem jeweiligen Bedarf entsprechenden Anschlusstechniken ausgestattet sein.

Reicht eine der beiden großflächigen Seiten des Biegewandlerelementes nicht aus, um auf ihrem Grundriss die gesamte notwendige Leiterstruktur unterzubringen, kann die Flexschaltung zumindest bereichsweise breiter als das Biegewandlerelement ausgebildet und längsseits um das Biegewandlerelement herumgelegt sein. Auf diese Weise verfügt die Flexschaltung über beiden großflächigen Seiten des Biegewandlerelementes zugeordnete Schaltungsabschnitte mit Bestandteilen der Leiterstruktur, wobei von Vorteil ist, dass die Schaltungsabschnitte zusammenhängen und somit in einem Arbeitsgang appliziert werden können.

Bei einer besonders vorteilhaften Ausgestaltung ist die Leiterstruktur mittels siebdrucktechnischen Maßnahmen auf den folienartigen flexiblen Träger aufgebracht. Die Leiterstruktur besteht hier beispielsweise aus einer siebgedruckten Leitpaste. Mit einer solchen Technik lassen sich große Stückzahlen pro zeiteinheit realisieren, so dass sich die gesamten Gestehungskosten für den Piezo-Biegewandler auf sehr niedrigem Niveau bewegen können.

Letzteres gilt insbesondere auch dann, wenn als Material für den flexiblen Träger ein Polyestermaterial verwendet wird.

Die Befestigung der Flexschaltung bzw. flexiblen Leiterplatte auf dem Biegewandlerelement erfolgt zweckmäßigerweise durch eine Klebeverbindung. Um dabei gleichzeitig die notwendige elektrische Kontaktierung zwischen der Leiterstruktur der Flexschaltung und den Elektroden des Arbeitsabschnittes vornehmen zu können, verwendet man bevorzugt wenigstens bereichsweise einen anisotrop leitfähigen Klebstoff, der einander gegenüberliegende Anschlusspads und Anschlussflächen elektrisch leitend verbindet, ohne an anderer Stelle einen Kurzschluss herbeizuführen.

Die Flexschaltung kann zumindest partiell einen Multilayeraufbau besitzen. Dies erlaubt die Realisierung komplexer Verläufe der Leiterstruktur zur Realisierung spezieller Sensoren. Man kann auf diese Weise beispielsweise zwei sich gegenüberliegende, kapazitiv wirkende leitende Flächen verwirklichen, die, gegebenenfalls unter Einschluss einer isolierenden oder als Dielektrikum wirkenden Zwischenschicht, einen Drucksensor bilden.

Der Piezo-Biegewandler kann beispielsweise als Stellglied für die unterschiedlichsten Aktoraufgaben eingesetzt werden. Als besonders zweckmäßig wird die Verwendung zur Betätigung eines Ventilgliedes oder eine unmittelbare Verwendung als Ventilglied bei einem Piezoventil angesehen, das zur Steuerung einer Fluidströmung, insbesondere einer Gasströmung, eingesetzt wird.

Nachfolgend wird die Erfindung anhand der beiliegenden Zeichnung näher erläutert. In dieser zeigen:
- Figur 1: einen möglichen Aufbau des erfindungsgemäßen Piezo-Biegewandlers in schematischer perspektivischer Darstellung im Zusammenhang mit einem Einsatz als Ventilglied eines Piezoventils, wobei einige Details nochmals gesondert in vergrößerten Ausschnitten wiedergegeben sind,
- Figur 2: den Piezo-Biegewandler aus Figur 1 in einer Einzeldarstellung vor der Vereinigung von Flexschaltung und Biegewandlerelement, und

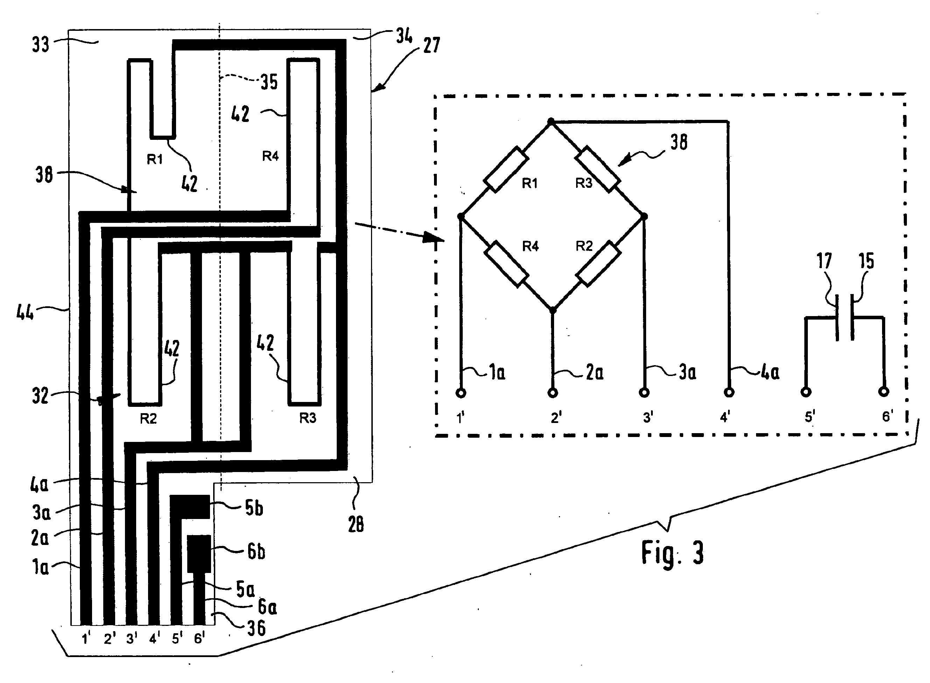

- Figur 3: eine Einzeldarstellung der bei dem Piezo-Biegewandler gemäß Figuren 1 und 2 vorhandenen Flexschaltung vor der Installation, ergänzt um eine gesonderte schematische Darstellung der realisierten Schaltungsfunktionalität.

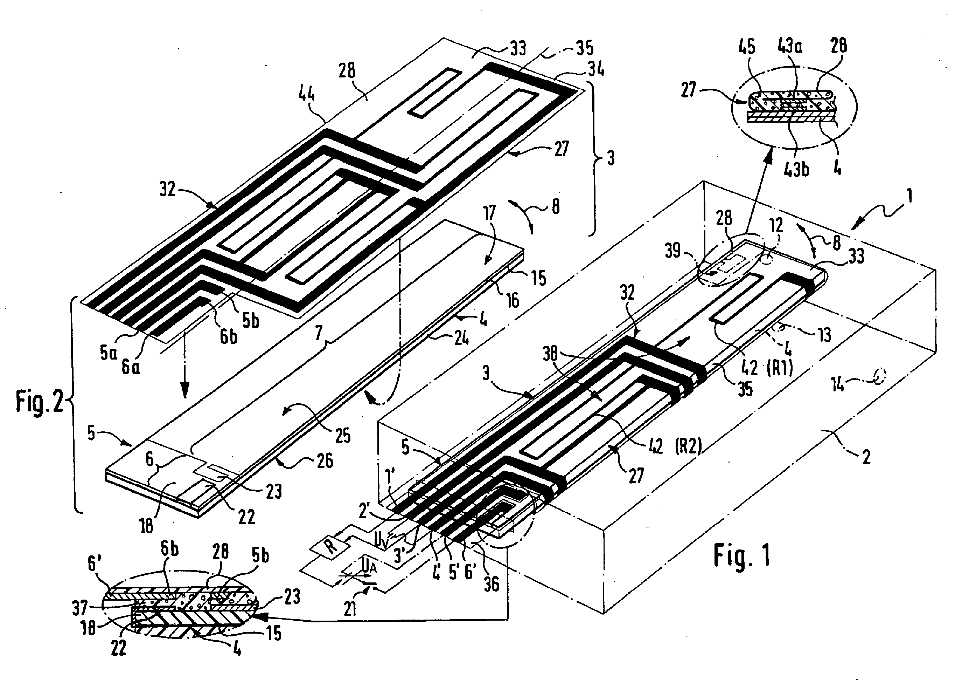

Die Figur 1 zeigt insgesamt in schematischer Weise ein zur Steuerung einer Fluidströmung dienendes Piezoventil 1. Dieses besitzt ein strichpunktiert angedeutetes Gehäuse 2, in dessen Innenraum ein als Stellglied fungierender Piezo-Biegewandler 3 hineinragt.

Der Piezo-Biegewandler 3 enthält ein aus Figur 2 gut ersichtliches streifenförmiges Biegewandlerelement 4, das an seinem rückwärtigen Endbereich 5 ventilgehäusefest fixiert ist. Bei anderen Anwendungen tritt an Stelle des Ventilgehäuses eine sonstige Aufhängungsstruktur für die Halterung des Biegewandlerelementes 4.

Der rückwärtige Endbereich 5 des Biegewandlerelementes 4 bildet einen Anschlussabschnitt 6, in dessen Bereich die für den Betrieb des Piezo-Biegewandlers 3 erforderliche elektrische Energie und elektrischen Signale zu- bzw. abgeführt werden. Der Anschlussabschnitt 6 enthält in der Regel kein piezoelektrisches Material und ist im Betrieb stets piezoelektrisch inaktiv.

An den Anschlussabschnitt 6 schließt sich nach vorne hin ein als Arbeitsabschnitt 7 bezeichneter Längenabschnitt des Biegewandlerelementes 4 an, der auf Grund eines entsprechenden Aufbaus piezoelektrisch aktivierbar ist. Durch entsprechende elektrische Aktivierung kann erreicht werden, dass der Arbeitsabschnitt 7 in einer zu seiner Ausdehnungsebene rechtwinkeligen Auslenkebene gemäß Doppelpfeil 8 seitwärts auslenkbar ist. Das Biegewandlerelement 4 wird dabei in die eine oder andere Richtung ausgebogen.

Durch die erwähnte Auslenkbewegung kann ein mit dem Biegewandlerelement 4 bewegungsgekoppeltes Ventilverschlussglied 12 relativ zu mindestens einer ventilgehäusefesten Ventilöffnung 13 positioniert werden, um den Fluiddurchfluss durch die Ventilöffnung 13 variabel vorzugeben. In der maximalen Offenstellung ist das Ventilverschlussglied 12 weitestmöglich von der Ventilöffnung 13 entfernt, so dass innerhalb des Gehäuses 2 eine Fluidströmung mit maximalem Durchfluss zwischen der Ventilöffnung 13 und einer weiteren Ventilöffnung 14 möglich ist. In einer Schließstellung wird die Ventilöffnung 13 durch das Ventilverschlussglied 12 verschlossen und jegliche Fluidströmung unterbunden. In Zwischenstellungen, die vom momentanen Grad der Auslenkung des Arbeitsabschnittes 7 abhängen, lässt sich die Durchströmrate zwischen dem Maximalwert und dem Minimalwert einstellen.

In der Regel wird das Piezoventil 1 so ausgelegt, dass bei deaktiviertem Biegewandlerelement 4 die Schließstellung vorliegt und entsprechend der Höhe der angelegten Spannung der Grad der Auslenkung und mithin der Öffnungsgrad vorgegeben werden kann. Allerdings wäre auch eine umgekehrte Auslegung möglich.

Beim Ausführungsbeispiel sitzt das Ventilverschlussglied 12 direkt am Biegewandlerelement 4. Es kann sich allerdings auch an einem gesonderten Ventilglied befinden, das durch den Piezo-Biegewandler 3 betätigbar ist.

Das Biegewandlerelement 4, das prinzipiell auch allgemein plattenartig gestaltet sein kann, besitzt beim Ausführungsbeispiel eine als erste Elektrode fungierende, elektrisch leitfähige Trägerschicht 15, insbesondere bestehend aus mit Kohlenstofffasern verstärktem Kunststoffmaterial. Die in der Zeichnung oben liegende Fläche der Trägerschicht 15 ist im Bereich des Arbeitsabschnittes 7 mit einer piezoelektrischen Materialschicht 16 belegt, beispielsweise einer Piezokeramik oder einem anderen, piezoelektrische Eigenschaften aufweisenden Material. Die der Trägerschicht 15 entgegengesetzte Oberfläche der piezoelektrischen Materialschicht 16 ist durch Besputtern elektrisch leitfähig gemacht und bildet eine zweite Elektrode 17. Alternativ könnte die zweite Elektrode 17 auch durch ein gesondertes, elektrisch leitfähiges Material definiert sein.

Im Bereich des Anschlussabschnittes 6 ist die Trägerschicht 15 im Anschluss an die piezoelektrische Materialschicht 16 mit einer piezoelektrisch inaktiven Materialschicht 18 belegt; beispielsweise einem Kunstharzmaterial.

Im Bereich des Anschlussabschnittes 6 weist das Biegewandlerelement 4 an der der Trägerschicht 15 entgegengesetzten großflächigen Oberseite zwei von elektrisch leitenden Flächen gebildete Anschlusspads 22, 23 auf, von denen das eine Anschlusspad 22 mit der als erster Elektrode fungierenden Trägerschicht 15 elektrisch leitend verbunden ist, während das zweite Anschlusspad 23 mit der zweiten Elektrode 17 in elektrisch leitender Verbindung steht.

Im deaktivierten, spannungslosen Zustand nimmt das Biegewandlerelement 4 die aus der Abbildung ersichtliche Strecklage ein. Zur Aktivierung wird an den beiden Anschlusspads 22, 23 eine Aktivierungsspannung UA eingespeist, was in der zwischen den beiden Elektroden 15, 17 angeordneten piezoelektrischen Materialschicht 16 eine Längenänderung hervorruft, so dass sich das Biegewandlerelement 4 krümmt und gleichzeitig die schon erwähnte Auslenkbewegung 8 ausführt.

Nach dem Wegnehmen der Ansteuerspannung und einem Entladen der beiden Elektroden 15, 17, kehrt das Biegewandlerelement 4 in seine Ausgangsstellung zurück. Der Auslenkhub ist variabel und hängt von der Höhe der momentan anliegenden Aktivierungsspannung ab.

Zur Kompensation von Temperaturdehnungen ist die Trägerschicht 15 an der Unterseite zweckmäßigerweise mit einer während des Betriebes piezoelektrisch nicht aktiven Kompensationsschicht 24 belegt. Sie kann beispielsweise aus einer inaktiven Piezokeramik bestehen. Es besteht allerdings ohne Weiteres die Möglichkeit, an Stelle der Kompensationsschicht 24 eine weitere, im Betrieb piezoelektrisch aktivierbare Anordnung vorzusehen, beispielsweise spiegelbildlich zu derjenigen auf der Oberseite der Trägerschicht 15. Dadurch kann das Biegewandlerelement 4 ausgehend von seiner Mittelstellung aktiv alternativ nach beiden Seiten ausgelenkt werden.

Eine das Anlegen und Wegnehmen der Betätigungsspannung ermöglichende Schaltvorrichtung ist in Figur 1 bei 21 angedeutet.

Im Folgenden seien die beiden großflächigen Seiten des Biegewandlerelementes 4 der besseren Unterscheidbarkeit wegen als Oberseite 25 und Unterseite 26 bezeichnet. Die Oberseite 25 ist diejenige Seite, auf der sich die piezoelektrisch aktivierbare Materialschicht 16 und die zugeordneten Anschlusspads 22, 23 befinden. Eine Einschränkung hinsichtlich Aufbau und Orientierung des Biegewandlerelementes 4 im Gebrauch ist mit den genannten Richtungsangaben nicht verbunden.

Außer dem schon erwähnten Biegewandlerelement 4 enthält der Piezo-Biegewandler 3 eine sogenannte flexible Leiterplatte oder Flexschaltung 27, über die unter anderem die der piezoelektrischen Aktivierung dienende elektrische Kontaktierung des Arbeitsabschnittes 7 erfolgt.

Die Flexschaltung 27 enthält einen folienartig dünnen, flexiblen Träger 28 aus nicht leitendem Kunststoffmaterial, wobei beim Ausführungsbeispiel ein Polyesterwerkstoff eingesetzt wird, der kostengünstig in der gewünschten Form bereitgestellt werden kann.

Auf dem flexiblen Träger 28 befindet sich eine elektrische Leiterstruktur 32 mit einer größeren Anzahl von teils separaten und teils miteinander verbundenen, elektrisch leitfähigen Leiterbahnen bzw. Leiterzügen.

Die Flexschaltung 27 ist flächig an das Biegewandlerelement 4 angesetzt und, insbesondere stoffschlüssig, fest mit diesem verbunden.

Beim Ausführungsbeispiel erstreckt sich die Flexschaltung 27 sowohl auf der Oberseite 25 als auch auf der Unterseite 26 des Biegewandlerelements 4. Ein erster Schaltungsabschnitt 33, dessen Breite etwa derjenigen des Biegewandlerelementes 4 entspricht, liegt auf der Oberseite 25. Ein gleich breiter oder auch schmälerer zweiter Schaltungsabschnitt 34 liegt auf der Unterseite 26. Die Montage am Biegewandlerelement 4 erfolgt derart, dass die Flexschaltung 27 in dem durch eine strichpunktierte Linie angedeuteten, längs verlaufenden Übergangsbereich 35 um 180° umgebogen und um das Biegewandlerelement 4 herumgefaltet wird. Der Übergangsbereich 35 kommt dabei im Bereich eines Längsrandes des Biegewandlerelementes 4 zu liegen.

Zur Realisierung dieser Konfiguration wird eine Flexschaltung 27 eingesetzt, die zumindest bereichsweise breiter ist als das Biegewandlerelement 4. Beim Ausführungsbeispiel erstreckt sich der breitere Bereich der Flexschaltung 27 und somit der Bereich der Doppelbelegung des Biegewandlerelementes 4 über die Länge des Arbeitsabschnittes 7. Der Anschlussabschnitt 6 ist nur an der Oberseite 25 von der Flexschaltung 27 überdeckt.

Durch eine solche Anordnung wird die Grundfläche der Flexschaltung 27 vergrößert, ohne den Raumbedarf des Piezo-Biegewandler 3 nennenswert zu erhöhen. Somit steht trotz kompakter Abmessungen eine große Fläche zur Realisierung der elektrischen Leiterstruktur 32 zur Verfügung.

Prinzipiell könnte die Flexschaltung 27 so ausgebildet sein, dass sie sowohl die Oberseite 25 als auch die Unterseite 26 vollständig überdeckt. Jedenfalls steht die größere Fläche zur Verfügung, ohne auf mehrere separate Flexschaltungen zurückgreifen zu müssen. Die beiden Schaltungsabschnitte 33, 34 sind integral miteinander verbunden.

Sofern es die gewünschte elektrische Schaltung zulässt, kann die Flexschaltung bzw. flexible Leiterplatte 27 in ihren Breitenabmessungen auch so auf das Biegewandlerelement 4 abgestimmt sein, dass es nur die Oberseite 25 oder nur die Unterseite 26 belegt.

Die elektrische Leiterstruktur 32 ist zweckmäßigerweise an der dem Biegewandlerelement 4 zugewandten Seite des flächenhaften Trägers 28 aufgebracht. In der Zeichnung wurde der Träger 28 der besseren Übersichtlichkeit wegen transparent dargestellt, so dass die Leiterstruktur 32 gut sichtbar ist.

Die Flexschaltung 27 ragt im Bereich des rückwärtigen Endbereiches 5 mit einem streifenförmigen Kontaktierungsabschnitt 36 über das Biegewandlerelement 4 hinaus. Dort enden auch mehrere Leiterzüge der elektrischen Leiterstruktur 32 mit Kontaktierungsenden 1' bis 6'.

Die beiden Kontaktierungsenden 5', 6' gehören zu zwei Aktivierungs-Leiterzügen 5a, 6a der Leiterstruktur 32, die im Bereich des Anschlussabschnittes 6 mit zwei Anschlussflächen 5b, 6b enden, die den beiden Anschlusspads 22, 23 gegenüberliegen. Bei montierter Flexschaltung 27 sind die Anschlussflächen 6b, 5b; 22, 23 paarweise elektrisch miteinander verbunden, so dass das Biegewandlerelement 4 aktiviert werden kann, indem an die Kontaktierungsenden 5', 6' der beiden Aktivierungsleiterzüge 5a, 6a die Aktivierungsspannung in gewünschter Höhe angelegt wird.

Die elektrische Kontaktierung der Anschlussflächen 6b, 5b und Anschlusspads 22, 23 erfolgt beim Ausführungsbeispiel durch einen anisotopen Leitkleber 37, mit dem die Flexschaltung 27 großflächig auf das Biegewandlerelement 4 aufgeklebt wird und der nur in den Bereichen sich gegenüberliegender elektrisch leitender Flächen eine elektrische Verbindung herstellt.

In besonders vorteilhafter Weise ist die Leiterstruktur 32 insgesamt so ausgebildet, dass sie nicht nur die für die Aktivierung des Arbeitsabschnittes 7 erforderlichen Aktivierungs-Leiterzüge 5a, 6a aufweist, sondern zusätzlich noch im Bereich des Arbeitsabschnittes 7 unmittelbar selbst mindestens einen Sensor 38, 39 bildet, mit dem sich wenigstens eine für die Ansteuerung des Biegewandlerelementes 4 relevante Zustandsgröße erfassen lässt. Ohne auf spezielle, eigenständige Sensoren zurückgreifen zu müssen, lässt sich somit eine gewünschte Sensorausstattung unmittelbar durch entsprechende Gestaltung der elektrischen Leiterstruktur 32 realisieren und äußerst kostengünstig herstellen.

Empfehlenswert ist es, die gesamte Leiterstruktur 32 im Rahmen eines Siebdruckverfahrens auf den flexiblen Träger 28 aufzudrucken. Ausgangsmaterial für die Leiterzüge ist hierbei insbesondere eine druckfähige Leitpaste. Die Kombination eines Druckverfahrens mit einem aus Polyestermaterial bestehenden Träger 28 erweist sich als besonders kostengünstig.

Prinzipiell wäre allerdings auch ein anderes Trägermaterial einsetzbar, beispielsweise Polyimid.

Da sich die für die Bildung und Kontaktierung des mindestens einen Sensors 38, 39 dienenden Bestandteile der Leiterstruktur 32 wenigstens teilweise über den Arbeitsabschnitt 7 hinweg erstrecken und dort auf einer Elektrode 17 zu liegen kommen können, wird die Leiterstruktur 32 vor der Installation der Flexschaltung 27 zweckmäßigerweise mit einer Isolierschicht überzogen, beispielsweise ein isolierender Lack, der mittels aus der Drucktechnik bekannten Verfahren aufgebracht werden kann.

Wird die Flexschaltung 27 mit dem Biegewandlerelement 4 verklebt, kann auch ein elektrisch nicht leitender Kleber eingesetzt werden, der ohne Erzeugung eines Kurzschlusses eine stoffschlüssige Verbindung herstellt. Ausgenommen hiervon sind allerdings die miteinander zu kontaktierenden Flächen im Bereich des Anschlussabschnittes 6.

Beim Ausführungsbeispiel definiert die Flexschaltung 27 einen Auslenkungssensor 38, der die Auslenkung des Biegewandlerelementes 4 erfasst. Dadurch sind Rückschlüsse auf die aktuelle Stellung des Arbeitsabschnittes 7 möglich und es kann bei Bedarf eine Nachregulierung durch entsprechende Anpassung der variablen Aktivierungsspannung UA vorgenommen werden.

Beim Ausführungsbeispiel ist der Auslenkungssensor 38 dadurch realisiert, dass diverse Leiterzüge 42 der Leiterstruktur 32 unter Bildung einer Widerstandsmessbrücke miteinander verschaltet sind. Durch diese Leiterzüge 42 werden vier zu einer als solches bekannten Brückenschaltung verknüpfte ohmsche Widerstände R1, R2, R3, R4 definiert, von denen die jeweils benachbarten unter Bildung eines insgesamt geschlossenen Widerstandskreises miteinander verbunden sind. Beim Auslenken des Biegewandlerelementes 4 werden die Leiterzüge 42 gedehnt oder gestaucht, woraus eine Änderung des durch sie jeweils vorgegebenen Widerstandswertes resultiert.

Von der Verbindung jeweils zweier aufeinanderfolgender Widerstände geht je ein als Sensor-Leiterzug 1a, 2a, 3a, 4a bezeichneter Leiterzug ab, der in Richtung zum Anschlussabschnitt 6 verläuft und sich wie die Aktivierungs-Leiterzüge 5a, 6a über den Anschlussabschnitt 6 hinweg erstreckt, um mit zugeordneten Kontaktierungsenden 1', 2', 3', 4' zu enden.

Für den Betrieb des Piezo-Biegewandlers 3 werden beim Ausführungsbeispiel am jeweils zugeordneten Kontaktierungsende zwei der Sensor-Leiterzüge 2a, 4a an eine Versorgungsspannung UV angeschlossen, während an den beiden anderen Sensor-Leiterzügen 1a, 3a die resultierende Messspannung abgegriffen wird.

Im Betrieb des Piezo-Biegewandlers 3 ergibt sich bei konstanter Versorgungsspannung für jeden Auslenkungswert des Arbeitsabschnittes 7 aufgrund der Dehnung oder Stauchung der Widerstände eine bestimmte Messspannung an den betreffenden Sensor-Leiterzügen 1a, 3a. Ändert sich durch mechanisches Kriechen oder Relaxation eine durch Vorgabe einer bestimmten Aktivierungsspannung eingestellte Auslenkung des Arbeitsabschnittes 7, verändert sich dadurch auch die Messspannung und man kann durch einen angeschlossenen elektronischen Regler R sehr leicht die Aktivierungsspannung UA so nachregeln, bis die abgegriffene Messspannung wieder den Ursprungswert erreicht hat und mithin gleichzeitig die Auslenkung des Arbeitsabschnittes 7 auf den Ursprungswert zurückgestellt wurde.

Es besteht auch die Möglichkeit, durch vorherige Kalibrierung ein Kennfeld zu erstellen, bei dem jedem Auslenkungswert ein bestimmter Messspannungswert zugeordnet ist, so dass die jeweils gewünschte Auslenkung anhand der im Betrieb erfassten Messspannung stets relativ genau eingehalten werden kann.

Indem die Flexschaltung 27 um das Biegewandlerelement 4 umgeschlagen ist, können die die Widerstände definierenden Leiterzüge 42 in optimaler Verteilung platziert werden, und zwar teils im Bereich der Oberseite 25 und teils im Bereich der Unterseite 26 des Biegewandlerelementes 4.

Zusätzlich oder alternativ zu dem Auslenkungssensor 38 kann die Leiterstruktur 32 auch mindestens einen andersartigen Sensor definieren. In Figur 1 ist hierzu exemplarisch ein weiterer Sensor 39 angedeutet, der als Drucksensor fungiert.

Um diesen zu realisieren, besitzt die Flexschaltung 27 beim Ausführungsbeispiel zumindest lokal einen Mehrschichtaufbau, wobei die Flexschaltung 27 ein- oder mehrfach gefaltet ist, so dass zwei Leiterzugabschnitte 43a, 43b einander mit Abstand gegenüberliegen. Ändert sich in der Umgebung dieser Leiterzugabschnitte 43a, 43b der herrschende Druck, insbesondere der Druck des zu steuernden Gases, verändert sich der Abstand zwischen den beiden Leiterzugabschnitten 43a, 43b mit der Folge einer Kapazitätsänderung, aus der sich der Druck bzw. eine Druckänderung ableiten lässt.

Auch die Leiterzugabschnitte 43a, 43b des einen Drucksensor 39 definierenden Teils der Leiterstruktur 32 stehen mit zum Anschlussabschnitt 6 führenden Sensor-Leiterzügen in Verbindung, die in der Zeichnung nicht näher dargestellt sind.

Bei einem Mehrschicht- bzw. Multilayeraufbau werden die übereinanderliegenden Schichten der Flexschaltung 27 zweckmäßigerweise durch einen zwischengefügten Klebstoff 45 zusammengehalten. Dieser kann auch einen gewissen Schichtabstand garantieren, wenn ein solcher für die Funktion des gebildeten Sensors notwendig oder zweckmäßig ist.

Als weitere Sensorarten, die durch entsprechende Gestaltung der elektrischen Leiterstruktur 32 realisierbar sind, seien an dieser Stelle exemplarisch noch Temperatursensoren und Feuchtesensoren genannt.

Bei der Herstellung der Flexschaltung 27 können die als Sensoren fungierenden Bestandteile der Leiterstruktur 32 sehr präzise in einer gewünschten Ausrichtung aufgebracht werden, so dass bei der anschließenden Vereinigung von Flexschaltung 27 und Biegewandlerelement 4 lediglich noch eine Ausrichtung zwischen diesen beiden Elementen notwendig ist, um die erforderliche Relativposition zwischen der Leiterstruktur 32 und dem Biegewandlerelement 4 zu erhalten. Die Flexschaltung 27 enthält hierzu zweckmäßigerweise mindestens eine Bezugsmarkierung 44, die leicht bezüglich dem Biegewandlerelement 4 ausrichtbar ist. Beim Ausführungsbeispiel ist sie von einem der linear verlaufenden längsseitigen Seitenränder des Trägers 28 gebildet, der sich bei der Montage sehr leicht parallel bezüglich einem der längsseitigen Ränder des Biegewandlerelementes 4 ausrichten lässt. Somit ergibt sich nicht nur eine Vereinfachung bei der Herstellung der Sensorik, sondern auch bei der Montage der Flexschaltung 27 am Biegewandlerelement 4.

Sofern sowohl an der Oberseite 25 als auch der Unterseite 26 des Anschlussabschnittes 6 Anschlusspads für die Kontaktierung des Arbeitsabschnittes 7 vorhanden sind, kann die Zuführung der notwendigen Aktivierungs-Leiterzüge auch hier sehr einfach mittels einer um das Biegewandlerelement 4 herumgefalteten Flexschaltung 27 vorgenommen werden.

## Patentansprüche

1. Piezo-Biegewandler, mit einem streifen- oder plattenförmigen Biegewandlerelement (4), das einen als piezoelektrisch aktivierbarer Arbeitsabschnitt (7) ausgebildeten Längenabschnitt aufweist und an wenigstens einer seiner beiden großflächigen Seiten (25, 26) mit einer einen folienartigen flexiblen Träger (28) und eine darauf verlaufende elektrische Leiterstruktur (32) aufweisenden Flexschaltung (27) bestückt ist, über die die der piezoelektrischen Aktivierung dienende elektrische Kontaktierung des Arbeitsabschnittes (7) erfolgt, **dadurch gekennzeichnet, dass** ein Teil der Leiterstruktur (32) der Flexschaltung (27) im Bereich des Arbeitsabschnittes (7) des Biegewandlerelementes (4) unmittelbar selbst mindestens einen wenigstens eine Zustandsgröße erfassenden Sensor (38, 39) bildet.

2. Piezo-Biegewandler nach Anspruch 1, **dadurch gekennzeichnet, dass** die Leiterstruktur (32) mindestens einen die Auslenkung des Biegewandlerelements (4) erfassenden Auslenkungssensor (38) bildet.

3. Piezo-Biegewandler nach Anspruch 1 oder 2, **dadurch gekennzeichnet, dass** die Leiterstruktur (32) zur Bildung mindestens eines Auslenkungssensors (38) über unter Bildung einer Widerstandsmessbrücke miteinander verschaltete Leiterzüge (42a, 42b) verfügt, die bei der Auslenkung des Arbeitsabschnittes (7) unter Änderung ihres elektrischen Widerstandes mehr oder weniger stark gedehnt und/oder gestaucht werden.

4. Piezo-Biegewandler nach einem der Ansprüche 1 bis 3, **dadurch gekennzeichnet, dass** die Leiterstruktur (32) mindestens einen Temperatursensor bildet.

5. Piezo-Biegewandler nach einem der Ansprüche 1 bis 4, **dadurch gekennzeichnet, dass** die Leiterstruktur (32) mindestens einen den in der Umgebung des Biegewandlerelements (4) herrschenden Druck erfassenden Drucksensor (39) bildet.

6. Piezo-Biegewandler nach einem der Ansprüche 1 bis 5, **dadurch gekennzeichnet, das**s die Leiterstruktur (32) mindestens einen Feuchtesensor bildet.

7. Piezo-Biegewandler nach einem der Ansprüche 1 bis 6, **dadurch gekennzeichnet, dass** das Biegewandlerelement (4) an einem Endbereich (5) einen sich an den Arbeitsabschnitt (7) anschließenden Anschlussabschnitt (6) aufweist, über den sich die Flexschaltung (27) mit der Kontaktierung des Arbeitsabschnittes (7) und des mindestens einen Sensors (38, 39) dienenden Leiterzügen (1a - 6a) hinweg erstreckt.

8. Piezo-Biegewandler nach Anspruch 7, **dadurch gekennzeichnet, dass** an dem Anschlussabschnitt (6) mit der Elektrodenanordnung (15, 17) des piezoelektrisch aktivierbaren Arbeitsabschnittes (7) verbundene Anschlusspads (22, 23) vorhanden sind, mit denen zur Leiterstruktur (32) gehörende Anschlussflächen (6b, 5b) der angesetzten Flexschaltung (27) kontaktiert sind.

9. Piezo-Biegewandler nach Anspruch 7 oder 8, **dadurch gekennzeichnet, dass** sich der den mindestens einen Sensor (38, 39) bildende Teil der Leiterstruktur (32) ausgehend von dem Anschlussabschnitt (6) in den Bereich des Arbeitsabschnittes (7) hinein erstreckt.

10. Piezo-Biegewandler nach einem der Ansprüche 1 bis 8, **dadurch gekennzeichnet, dass** die Flexschaltung (27) zumindest bereichsweise breiter als das Biegewandlerelement (4) ausgebildet und längsseits um das Biegewandlerelement (4) herumgefaltet ist, wobei sowohl der diesseitige als auch der jenseitige Schaltungsabschnitt (33, 34) Bestandteile der Leiterstruktur (32) aufweisen kann.

11. Piezo-Biegewandler nach einem der Ansprüche 1 bis 10, **dadurch gekennzeichnet, dass** die Leiterstruktur (32), insbesondere durch Siebdruck, auf den flexiblen Träger (28) aufgedruckt ist.

12. Piezo-Biegewandler nach einem der Ansprüche 1 bis 11, **dadurch gekennzeichnet, dass** der Träger (28) aus Polyimidmaterial oder, insbesondere, aus Polyestermaterial besteht.

13. Piezo-Biegewandler nach einem der Ansprüche 1 bis 12, **dadurch gekennzeichnet, dass** die Flexschaltung (27) flächig auf das Biegewandlerelement (4) aufgeklebt ist, insbesondere wenigstens teilweise mittels eines anisotrop leitfähigen Klebstoffes (37).

14. Piezo-Biegewandler nach einem der Ansprüche 1 bis 13, **dadurch gekennzeichnet, dass** die Flexschaltung (27) zumindest partiell einen Mulitlayeraufbau besitzt.

15. Piezo-Biegewandler nach einem der Ansprüche 1 bis 14 zur Verwendung als Stellglied bei einem zur Steuerung einer Fluidströmung, insbesondere einer Gasströmung, dienenden Piezoventil (1).

## Claims

1. Piezoelectric bending transducer with a strip- or panel-shaped bending transducer element (4) having a length section designed as a piezoelectrically actuable operating section (7) and loaded on at least one of its two large sides (25, 26) with a flexible circuit (27), containing a film-like flexible substrate (28) and an electrical conductor pattern (32) running thereon, via which the electrical contacting of the operating section (7) which serves for the piezoelectric activation is effected, **characterised in that** a part of the conductor pattern (32) of the flexible circuit (27) in the area of the operating section (7) of the bending transducer element (4) directly forms one or more sensors (38, 39) detecting a state variable.

2. Piezoelectric bending transducer according to claim 1, **characterised in that** the conductor pattern (32) forms one or more deflection sensors (38) detecting the deflection of the bending transducer element (4).

3. Piezoelectric bending transducer according to claim 1 or 2 **characterised in that**, to form one or more deflection sensors (38), the conductor pattern (32) has interconnected conductor runs (42a, 42b) forming a resistance bridge and which, in the deflection of the operating section (7), are more or less strongly stretched or compressed with a change in their electrical resistance.

4. Piezoelectric bending transducer according to any of claims 1 to 3, **characterised in that** the conductor pattern (32) forms one or more temperature sensors.

5. Piezoelectric bending transducer according to any of claims 1 to 4, **characterised in that** the conductor pattern (32) forms one or more pressure sensors (39) detecting the pressure prevailing in the vicinity of the bending transducer element (4).

6. Piezoelectric bending transducer according to any of claims 1 to 5, **characterised in that** the conductor pattern (32) forms one or more moisture sensors.

7. Piezoelectric bending transducer according to any of claims 1 to 6, **characterised in that** the bending transducer element (4) has at one end section (5) a terminal section (6) adjoining the operating section (7), over which extends the flexible circuit (27) in the contacting of the operating section (7) and the conductor runs (1a - 6a) serving one or more sensors (38, 39).

8. Piezoelectric bending transducer according to claim 7 **characterised in that** there are provided, on the terminal section (6) with the electrode assembly (15, 17) of the piezoelectrically actuable operating section (7), terminal pads (22, 23) by which terminal faces (6b, 5b) of the attached flexible circuit (27) belonging to the conductor pattern (32) are contacted.

9. Piezoelectric bending transducer according to claim 7 or 8, **characterised in that** the part of the conductor pattern (32) forming the sensor or sensors (38, 39) extends from the terminal section (6) into the area of the operating section (7).

10. Piezoelectric bending transducer according to any of claims 1 to 8, **characterised in that** the flexible circuit (27) is at least in some areas wider than the bending transducer element (4) and on the long side is folded around the bending transducer element (4), wherein both the circuit section (33, 34) on this side and that on the other side may have elements of the conductor pattern (32).

11. Piezoelectric bending transducer according to any of claims 1 to 10, **characterised in that** the conductor pattern (32) is printed on to the flexible substrate (28), in particular by screen printing.

12. Piezoelectric bending transducer according to any of claims 1 to 11, **characterised in that** the substrate (28) is made of polyimide material, or in particular of polyester material.

13. Piezoelectric bending transducer according to any of claims 1 to 12, **characterised in that** the flexible circuit (27) is bonded flat on to the bending transducer element (4), in particular at least partly using an anisotropic conductive adhesive (37).

14. Piezoelectric bending transducer according to any of claims 1 to 13, **characterised in that** the flexible circuit (27) has at least partly a multilayer structure.

15. Piezoelectric bending transducer according to any of claims 1 to 14, for use as control element in a piezoelectric valve (1) used to control a fluid flow, in particular a gas flow.

## Revendications

1. Transducteur piézo à flexion, avec un élément transducteur à flexion (4) en forme de bande ou de plaque, qui présente une section de longueur conformée en section de travail (7) activable piézoélectriquement et qui est recouvert, sur au moins l'une de ses deux faces (25 26) de grande surface, avec un circuit flexible (27) présentant un support flexible (28) de type feuille et une structure conductrice électrique (32) s'étendant par-dessus, circuit par l'intermédiaire duquel s'effectue la mise en contact électrique de la section de travail (7) servant à l'activation piézoélectrique, **caractérisé en ce qu'**une partie de la structure conductrice (32) du circuit flexible (27) forme, au niveau de la section de travail (7) de l'élément transducteur à flexion (4), elle-même directement au moins un capteur (38, 39) détectant au moins une grandeur d'état.

2. Transducteur piézo à flexion selon la revendication 1, **caractérisé en ce que** la structure conductrice (32) forme au moins un capteur de déformation (38) détectant la déformation de l'élément transducteur à flexion (4).

3. Transducteur piézo à flexion selon la revendication 1 ou 2, **caractérisé en ce que** la structure conductrice (32) dispose, pour former au moins un capteur de déformation (38), des pistes conductrices (42a, 42b) reliées entre elles en formant un pont de mesure de résistance, qui sont plus ou moins fortement étirées et/ou comprimées lors d'une déformation de la section de travail (7), ce qui modifie leur résistance électrique

4. Transducteur piézo à flexion selon l'une des revendications 1 à 3, **caractérisé en ce que** la structure conductrice (32) forme au moins un capteur de température.

5. Transducteur piézo à flexion selon l'une des revendications 1 à 4, **caractérisé en ce que** la structure conductrice (32) forme au moins un capteur de pression (39) détectant la pression qui règne dans l'environnement de l'élément transducteur à pression (4).

6. Transducteur piézo à flexion selon l'une des revendications 1 à 5, **caractérisé en ce que** la structure conductrice (32) forme au moins un capteur d'humidité.

7. Transducteur piézo à flexion selon l'une des revendications 1 à 6, **caractérisé en ce que** l'élément transducteur à flexion (4) présente dans une zone d'extrémité (5) une section de raccordement (6) se raccordant à la section de travail (7), sur laquelle s'étend le circuit flexible (27) avec des pistes conductrices (1a - 6a) servant à la connexion de la section de travail (7) et du capteur (38, 39) au nombre d'au moins un.

8. Transducteur piézo à flexion selon la revendication 7, **caractérisé en ce que** sur la section de raccordement (6) se trouvent des plages de raccordement (22, 23) reliées au système d'électrodes (15 , 17) de la section de travail (7) activable piézoélectriquement, plages avec lesquelles sont mises en contact des surfaces de raccordement (6b, 5b) du circuit flexible (27) rapporté qui appartiennent à la structure conductrice (32).

9. Transducteur piézo à flexion selon la revendication 7 ou 8, **caractérisé en ce que** la partie de la structure conductrice (32) formant le capteur (38, 39) au nombre d'au moins un s'étend dans la zone de la section de travail (7) partant de la section de raccordement (6).

10. Transducteur piézo à flexion selon l'une des revendications 1 à 8, **caractérisé en ce que** le circuit flexible (27) est réalisé au moins par endroits plus large que l'élément transducteur à flexion (4) et est replié sur un côté longitudinal autour de l'élément transducteur à flexion (4), tant la section de circuit de ce côté que celle de l'autre côté (33, 34) pouvant présenter des parties de la structure conductrice (32).

11. Transducteur piézo à flexion selon l'une des revendications 1 à 10, **caractérisé en ce que** la structure conductrice (32) est imprimée sur le support flexible (28), en particulier par sérigraphie.

12. Transducteur piézo à flexion selon l'une des revendications 1 à 11, **caractérisé en ce que** le support (28) est constitué d'un matériau de type polyimide, en particulier d'un matériau polyester.

13. Transducteur piézo à flexion selon l'une des revendications 1 à 12, **caractérisé en ce que** le circuit flexible (27) est collé à plat sur l'élément transducteur à flexion (4), en particulier au moins partiellement au moyen d'un adhésif (37) à conduction anisotrope.

14. Transducteur piézo à flexion selon l'une des revendications 1 à 13, **caractérisé en ce que** le circuit flexible (27) possède au moins partiellement une structure multicouches.

15. Transducteur piézo à flexion selon l'une des revendications 1 à 14, destiné à une utilisation comme organe de réglage dans une vanne piézoélectrique (1) servant à commander un écoulement de fluide, en particulier un écoulement de gaz.
